# EUROPÄISCHE PATENTSCHRIFT

(11) **EP 2 983 938 B1**
(45) Veröffentlichungstag und Bekanntmachung des Hinweises auf die Patenterteilung: **28.03.2018**
(21) Anmeldenummer: 14715832.3
(22) Anmeldetag: 28.03.2014
(51) Int. Cl.: B60K 37/06, B60K 35/00, C03C 17/00, G06F 3/0488, G06F 3/0354

(54) **VERFAHREN ZUM HERSTELLEN EINES BEDIENELEMENTS UND BEDIENELEMENT**
METHOD FOR PRODUCING A CONTROL ELEMENT AND CONTROL ELEMENT
PROCÉDÉ DE FABRICATION D'UN ÉLÉMENT DE COMMANDE ET ÉLÉMENT DE COMMANDE

(30) Priorität: 08.04.2013 DE 102013006069
(43) Veröffentlichungstag der Anmeldung: 17.02.2016
(73) Patentinhaber: Audi AG, 85045 Ingolstadt (DE)
(72) Erfinder: MÜLLER, Ulrich, 85055 Ingolstadt (DE); SCHNEIDER, Johann, 85139 Wettstetten (DE); KÜHNE, Marcus, 92339 Beilngries (DE); WACHINGER, Michael, 86571 Winkelhausen (DE)
(74) Vertreter: Brandt, Kai
(86) Internationale Anmeldenummer: PCT/EP2014/000843
(87) Internationale Veröffentlichungsnummer: WO 2014/166598

(56) Entgegenhaltungen:
- WO-A1-01/57843
- WO-A1-2005/015319
- DE-A1- 3 844 392
- US-A- 4 340 813
- Anonymous: "Siebdruck - Wikipedia", , 22. Januar 2013 (2013-01-22), Seiten 1-29, XP055156170, Internet Gefunden im Internet: URL:https://web.archive.org/web/2013012204 0058/http://de.wikipedia.org/wiki/Siebdruc k [gefunden am 2014-12-02]

## Beschreibung

Die Erfindung betrifft ein Verfahren zum Herstellen eines Bedienelements mit einer berührungsempfindlichen Oberfläche, bei welchem auf eine Trägerplatte ein pastöses Material aufgebracht wird. Des Weiteren betrifft die Erfindung ein Bedienelement zum Ansteuern von Funktionseinheiten eines Kraftwagens.

Bedienelemente mit berührungsempfindlichen Oberflächen finden als Mittel zur Eingabe von Benutzerinstruktionen zunehmend Anwendung in Kraftwagen, beispielsweise zum Ansteuern von Funktionseinheiten wie Infotainmentsystemen.

Die DE 38 44 392 A1 beschreibt ein als kapazitives Tastbedienungsfeld ausgebildetes Bedienfeld für ein Kochfeld. Hierbei sind auf einer Trägerplatte aus gehärtetem Glas Tastflächen hergestellt. Die Tastflächen werden durch Siebdrucken einer dekorativen Schicht aus weißer Keramikglasur über einer schwarzen Elektrode festgelegt. Als Material für die schwarze Elektrode kommt eine Paste zum Einsatz, welche auf das gehärtete Glas durch Siebdrucken aufgebracht wird.

Die US 4 340 813 A beschreibt eine Instrumententafel für ein Kraftfahrzeug, bei welcher auf eine Glasplatte Markierungen durch Siebdrucken aufgebracht werden, welche einen Schaltbereich umgeben.

Auf der Webseite http://de.wikipedia.org/wiki/Siebdruck vom 22.01.2013 ist angegeben, dass möglicherweise japanische Schablonentechniken Vorläufer des heutigen Siebdruckverfahrens waren. Bei den japanischen Schablonentechniken kommen Schablonen aus einem mit Pflanzenharz wasserfest gemachten, dicken Papier zum Einsatz, wobei die einzelnen Elemente der Schablonen durch stehengelassene Verbindungsstege aneinander fixiert oder durch ein Netz aus Fäden miteinander verbunden sind.

Die EP 1 352 384 B1 beschreibt die Herstellung eines Touchscreens, bei welchem auf eine Trägerplatte aus Glas eine Widerstandsschicht aufgebracht wird. Das Aufbringen eines Musters leitfähiger Kantenelektroden und von Verdrahtungsbahnen auf die Widerstandsschicht erfolgt durch ein Siebdruckverfahren, bei welchem eine Silberfrittenpaste auf die Widerstandsschicht aufgedruckt wird.

Auch die US 2002/0197455 A1 beschreibt das Aufbringen von Elektroden auf eine Isolationsschicht eines Touchscreens. Hierbei überdeckt die Isolationsschicht eine auf einem Glassubstrat angeordnete Widerstandsschicht, und die Elektroden werden auf der Isolationsschicht mittels eines Siebdruckverfahrens ausgebildet.

Die US 2010/0200539 A1 beschreibt ein Verfahren zum Herstellen eines Touchscreens, bei welchem auf einem Kunststoffsubstrat eine Schicht aus Indium-Zinn-Oxid angeordnet wird. Auf diese Oxidschicht wird Ätzpaste aufgebracht. Durch Erhöhen der Temperatur wird die Oxidschicht an den mit der Ätzpaste versehenen Stellen entfernt und so das Kunststoffsubstrat freigelegt.

Die DE 10 2006 021 270 A1 beschreibt das Aufdrucken von Bediensymbolen auf eine Acrylblende mittels Siebdruck.

Die WO 2007/017485 A2 beschreibt einen Touchscreen, bei welchem eine Schicht aus organischen Leuchtdioden mittels eines Druckverfahrens auf Elektroden aufgebracht wird, welche auf einem Substrat angeordnet sind.

Aufgabe der vorliegenden Erfindung ist es, ein Verfahren der eingangs genannten Art sowie ein mittels des Verfahrens erhältliches Bedienelement zu schaffen, bei welchem sich besonders gut definierte Strukturelemente auf der Trägerplatte ausbilden lassen bzw. vorhanden sind.

Diese Aufgabe wird durch ein Verfahren mit den Merkmalen des Patentanspruchs 1 und durch ein Bedienelement mit den Merkmalen des Patentanspruchs 5 gelöst. Vorteilhafte Ausgestaltungen mit zweckmäßigen Weiterbildungen der Erfindung sind in den abhängigen Patentansprüchen angegeben.

Bei dem erfindungsgemäßen Verfahren wird durch das pastöse Material auf der Trägerplatte wenigstens ein erhabenes Strukturelement ausgebildet. Dies geschieht, indem zunächst über der Trägerplatte eine eigensteife Schablone angeordnet wird. Dann wird das pastöse Material durch wenigstens eine Aussparung in der Schablone hindurchgedrückt. Die Kontur der Aussparung gibt somit die Kontur des mit der Aussparung korrespondierenden Strukturelements vor. Durch den Rand der Aussparung wird hierbei auch ein sauberer, definierter Rand des Strukturelements vorgegeben.

Zudem ist vorteilhaft, dass die Aussparung in der Schablone frei von jeglichen Fäden, Fasern oder Maschen ist, wie sie bei der Anwendung eines Siebdruckverfahrens vorhanden sind. Wenn bei einem Siebdruckverfahren nämlich das pastöse Material durch für dieses durchlässige Gewebebereiche hindurchgedrückt wird, so weist das dann auf die Trägerplatte aufgebrachte pastöse Material eine gewisse Unebenheit, Welligkeit und ausgefranste Ränder auf. Insbesondere zeichnen sich die Fäden des Gewebes oder Siebs auf der Oberfläche des Strukturelements ab, und entsprechend weist das durch ein Siebdruckverfahren hergestellte Strukturelement eine unregelmäßige Oberfläche auf.

Demgegenüber ist durch die Verwendung der eigensteifen Schablone mit der wenigstens einen Aussparung eine besonders saubere und gute Definition der Strukturelemente erreichbar, da im Bereich der Aussparungen in der Schablone eben keine Fäden oder dergleichen vorhanden sind. Zudem kann ein besonders dickflüssiges und festes pastöses Material zum Einsatz kommen, da ein Verlaufen der Paste nach dem Entfernen eines bei einem Siebdruckverfahren zum Einsatz kommenden Siebs nicht mehr notwendig ist.

Dadurch, dass die erhabenen Strukturelementen auf der Trägerplatte saubere Ränder und eine definierte Höhe aufweisen, sind diese optisch besonders ansprechend. Zudem lässt sich durch die Wahl einer jeweiligen Form der Aussparung eine gewünschte Form des jeweiligen Strukturelements bereitstellen. Neben der Verwendung der Strukturelemente auf der Trägerplatte als Designelemente lassen sich durch die erhabenen Strukturelemente auch haptische Landschaften darstellen sowie mit dem menschlichen Finger ertastbare Strukturen.

Wenn das pastöse Material Farbpigmente enthält, ist auch bei der Wahl der Farbe der erhabenen Strukturelemente eine besonders große Flexibilität gegeben.

Bei dem erfindungsgemäßen Verfahren wird die wenigstens eine Aussparung in der Schablone derart mit dem pastösen Material beaufschlagt, dass eine Höhe des wenigstens einen Strukturelements einer Dicke der Schablone entspricht. Die Höhe der Strukturelemente kann also sowohl über die Wahl der Konsistenz des pastösen Materials als auch über die - gegebenenfalls lokal unterschiedliche - Dicke der Schablone gezielt eingestellt werden. Dies ermöglicht es insbesondere, Strukturelemente vergleichsweise großer Höhe auf der Trägerplatte auszubilden, welche dann besonders gut haptisch wahrnehmbar sind.

Wollte man Strukturelemente einer besonders großen Höhe mittels eines Siebdruckverfahrens bereitstellen, so würde dies den Einsatz eines Gewebes mit besonders dicken Fäden notwendig machen. Diese dickeren Fäden würden sich dann aber besonderst stark in dem Strukturelement abzeichnen. Demgegenüber ist durch Auffüllen der Aussparung in der eigensteifen Schablone mit dem pastösen Material ein entsprechendes Strukturelement einer vergleichsweise großen Höhe bereitstellbar, welches frei von irgendwelchen Unregelmäßigkeiten aufgrund sich abzeichnender Fäden oder dergleichen ist.

Bei dem erfindungsgemäßen Verfahren wird durch das wenigstens eine erhabene Strukturelement eine Fühlhilfe für einen Benutzer des Bedienelements bereitgestellt. Das Vorsehen von solchen Fühlhilfen oder Orientierungshilfen auf der Trägerplatte - etwa in Form von Stegen, Bögen oder dergleichen - ermöglicht es dem Benutzer, auf dem Bedienelement zuverlässig Bedienhandlungen vorzunehmen, ohne dass der Benutzer seinen Blick auf die berührungsempfindliche Oberfläche des Bedienelements richten muss. Dies ist insbesondere dann von Vorteil, wenn das Bedienelement in einem Kraftwagen zum Einsatz kommt, da dann der Benutzer, etwa der Fahrer des Kraftwagens, seinen Blick nicht vom Verkehrsgeschehen abzuwenden braucht. Vielmehr kann er die Bereiche des Bedienelements, welche er zum Vornehmen von Bedienhandlungen berühren möchte, anhand der Fühlhilfen ausfindig machen.

Bei dem erfindungsgemäßen Verfahren wird die eigensteife Schablone durch ein Blech gebildet. In einem solchen Blech lassen sich nämlich Aussparungen oder Löcher, welche die Form der zu bildenden erhabenen Strukturelement vorgeben, besonders einfach und sauber bereitstellen. Dies ist günstig für die Vorgabe entsprechend sauber definierter Strukturelemente mittels der Aussparungen.

Als vorteilhaft hat es sich gezeigt, wenn als pastöses Material ein keramisches Material auf die Trägerplatte aufgebracht wird. Die dann aus dem keramischen Material gebildeten Strukturelemente sind nämlich besonders abriebfest und kratzfest, so dass sie eine besonders große Robustheit und Langlebigkeit aufweisen.

Als weiter vorteilhaft hat es sich gezeigt, wenn das pastöse Material durch Erhitzen mit der Trägerplatte verbunden wird. So lässt sich ein besonders inniger und zugleich stabiler, also die Struktur der Trägerplatte nicht schwächender Verbund der Strukturelemente mit der Trägerplatte erreichen.

Insbesondere, wenn als pastöses Material ein keramisches Material auf die Trägerplatte aufgebracht wird, ist es günstig, die Trägerplatte - oder zumindest deren Oberfläche - aus einem Glas zu bilden, da sich keramische Strukturelemente mit dem Glas besonders gut durch Erhitzen verbinden lassen.

Die wenigstens eine Aussparung in dem Blech kann insbesondere durch Laserschneiden und/oder durch Stanzen hergestellt werden. Mit derartigen Trennverfahren lassen sich nämlich besonders saubere und gerade Ränder der Aussparungen bereitstellen, welche wiederum zu entsprechend gut definierten und geraden Rändern der Strukturelemente führen.

Das erfindungsgemäße Bedienelement, welches zum Ansteuern von Funktionseinheiten eines Kraftwagens vorgesehen ist, umfasst eine Trägerplatte und es weist eine berührungsempfindliche Oberfläche auf. Auf der Trägerplatte ist wenigstens ein erhabenes Strukturelement ausgebildet, welches durch Hindurchdrücken eines pastösen Materials durch wenigstens eine Aussparung in einer eigensteifen, durch ein Blech gebildeten Schablone hergestellt ist. Die wenigstens eine Aussparung in der Schablone ist frei von jeglichen Fäden, Fasern oder Maschen, und eine Höhe des wenigstens einen Strukturelements entspricht einer Dicke der Schablone. Durch das wenigstens eine erhabene Strukturelement ist eine haptisch wahrnehmbare Fühlhilfe für einen Benutzer des Bedienelements bereitgestellt, und das wenigstens eine erhabene Strukturelement ist frei von irgendwelchen Unregelmäßigkeiten aufgrund sich abzeichnender Fäden oder dergleichen. Das wenigstens eine erhabene Strukturelement ist so besonders gut definiert und weist keine Unebenheiten, Welligkeiten, ausgefransten Ränder oder dergleichen auf, sondern eine besonders ebene Oberfläche und besonders scharf umrissene Konturen. Dies macht die erhabenen Strukturelemente besonders gut dazu geeignet, für einen Benutzer des Bedienelements die Fühlhilfen bzw. Orientierungshilfen bereitzustellen.

Das Bedienelement kann insbesondere als Touchpad oder als Touchscreen ausgebildet sein, über welchen sich die Funktionseinheiten des Kraftwagens ansteuern lassen.

Die für das erfindungsgemäße Verfahren beschriebenen Vorteile und bevorzugten Ausführungsformen gelten auch für das erfindungsgemäße Bedienelement und umgekehrt.

Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Weitere Vorteile, Merkmale und Einzelheiten der Erfindung ergeben sich aus den Ansprüchen, der nachfolgenden Beschreibung bevorzugter Ausführungsformen sowie anhand der Zeichnungen. Dabei zeigen:
- Fig. 1: ein aus dem Stand der Technik bekanntes Verfahren, bei welchem mittels Siebdruck eine Druckfarbe auf einen Bedruckstoff aufgebracht wird;
- Fig. 2: schematisch eine vergrößerte Darstellung eines durch das Siebdruckverfahren gemäß Fig. 1 erhaltenen und sich dann auf dem Bedruckstoff befindenden Strukturelements;
- Fig. 3: das Aufbringen von aus einer Keramikpaste gebildeten Strukturelementen auf eine Glasoberfläche eines in Fig. 5 gezeigten Bedienelements, wobei eine gelochte Schablone aus Blech verwendet wird;
- Fig. 4: schematisch eine vergrößerte Darstellung eines der durch das Verfahren gemäß Fig. 3 erhaltenen und sich dann auf der Glasoberfläche befindenden Strukturelemente; und
- Fig. 5: das Bedienelement mit der Oberfläche aus Glas, auf welche die Strukturelemente aus Keramik mittels des anhand von Fig. 3 veranschaulichten Verfahrens aufgebracht sind.

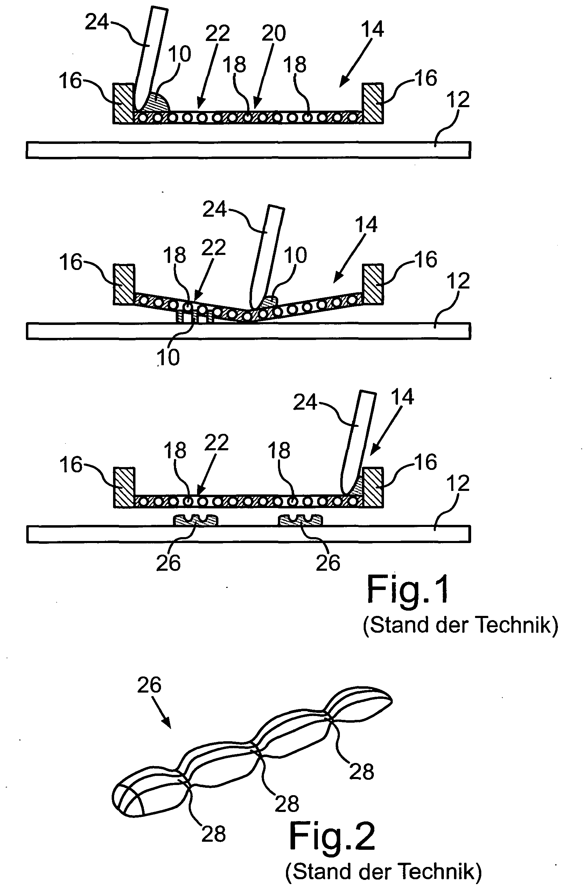

Anhand von Fig. 1 soll das aus dem Stand der Technik bekannte Siebdruckverfahren veranschaulicht werden, mittels welchem sich Druckfarbe 10 auf einem Bedruckstoff 12 aufbringen lässt.

Beim Siebdruckverfahren kommt ein Sieb 14 zum Einsatz, welches einen mit einem Gewebe bespannten Rahmen 16 umfasst. Die einzelnen Fäden 18 des Gewebes sind in Fig. 1 schematisch dargestellt. Das Gewebe wird mit einem Material, beispielsweise einem Fotopolymer, beschichtet und dann in Bereichen 20 belichtet, in welchen keine Farbe auf den Bedruckstoff 12 gelangen soll. An den übrigen Stellen 22 wird das nicht erhärtete Fotopolymer ausgewaschen. In dem Sieb 14 wechseln sich dann die für Druckfarbe 10 undurchlässige Bereiche 20 des Gewebes mit den Stellen 22 des Gewebes ab, an welchen die Druckfarbe 10 durch das Sieb 14 hindurchgedrückt werden kann.

Mit einem Rakel 24 wird an diesen Stellen 22 die Druckfarbe 10 durch das Gewebe hindurchgedrückt, und sie gelangt auf den Bedruckstoff 12 (vgl. die mittlere Abbildung in Fig. 1). Anschließend verläuft die Druckfarbe 10 auf dem Bedruckstoff 12 im Bereich der Stellen 22, und sie bildet Strukturen 26, in welchen sich die Fäden 18 des Gewebes abzeichnen.

Entsprechend weisen die Strukturen 26 auf dem Bedruckstoff 12 Unebenheiten, Welligkeiten oder Einschnürungen 28 an den Stellen auf, an welchen sich während des Aufbringens der Druckfarbe 10 auf den Bedruckstoff 12 die Fäden 18 des Siebs 14 befinden (vgl. Fig. 2).

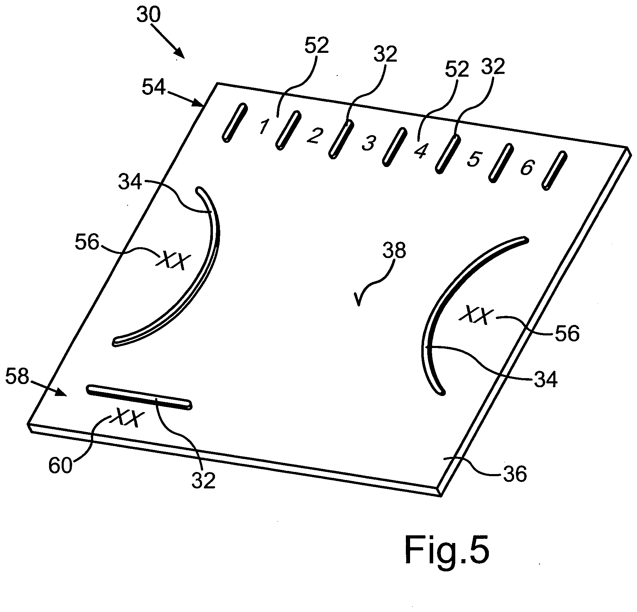

Die unregelmäßige Form, welche die durch das Siebdruckverfahren erhältlichen Strukturen 26 aufweisen, ist nicht wünschenswert. Daher wird vorliegend ein anderes Verfahren angewendet, um auf einem Bedienelement wie beispielsweise einem Touchpad 30 erhabene Strukturelemente etwa in Form von Stegen 32 oder Bögen 34 auszubilden (vgl. Fig. 5).

Zum Aufbringen erhabener Strukturelemente, welche als Fühlhilfen dienen können, auf eine Oberfläche 38 des Touchpads 30 ist nämlich auch ein Tampon-Druckverfahren nicht geeignet, bei welchem das zu übertragende pastöse Material zunächst auf einem Stempel angeordnet und dann auf den zu bedruckenden Träger übertragen wird. Die auf diese Weise aufbringbare Menge an Farbe oder Paste reicht nämlich nicht aus, um als Fühlhilfen einsetzbare erhabene Strukturen auszubilden.

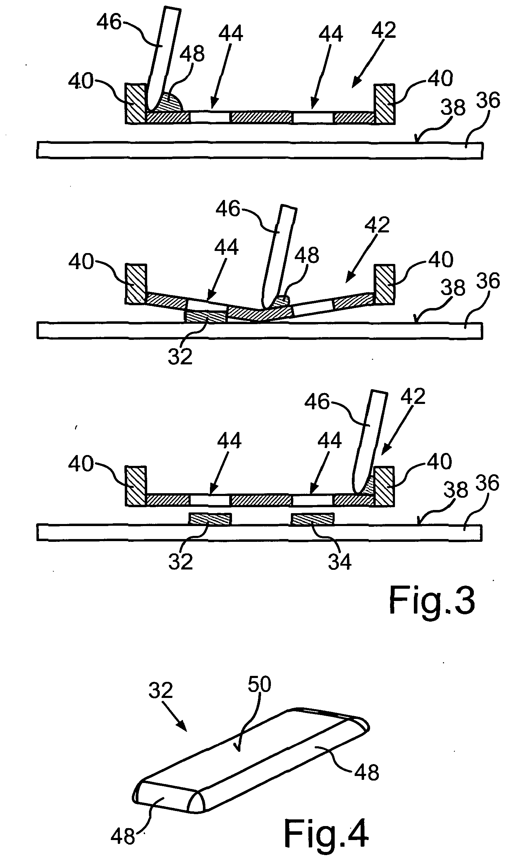

Das Touchpad 30 weist eine Trägerplatte 36 aus Glas auf, auf deren Oberfläche 38 die Stege 32 und Bögen 34 ausgebildet werden (vgl. Fig. 5). Die Vorgehensweise bei der Ausbildung dieser Strukturelemente wird anhand von Fig. 3 veranschaulicht.

Über der Trägerplatte 36 wird eine in einem Rahmen 40 gehaltene Schablone 42 angeordnet. Die eigensteife Schablone 42 ist aus einem Blech gebildet, in welchem Aussparungen 44 in Form von Löchern oder Schlitzen oder dergleichen vorgesehen sind. Die Aussparungen 44 befinden sich an den Stellen, an welchen auf der Trägerplatte 36 die Stege 32 und Bögen 34 angeordnet werden sollen. Mit einem Rakel 46 oder dergleichen Werkzeug wird dann eine Keramikpaste 48 durch die Aussparungen 44 in der Schablone 42 hindurchgedrückt (vgl. die mittlere Abbildung in Fig. 3). Der durch die jeweiligen Aussparungen 44 hindurchgedrückte Teil der Keramikpaste 48 bildet auf der Oberfläche 38 der Trägerplatte 36 die erhabenen Strukturelemente etwa in Form der Stege 32 oder Bögen 34 (vgl. die mittlere und die untere Abbildung in Fig. 3).

Die Aussparungen 44 in dem Blech der Schablone 42 können gelasert oder gestanzt sein. Dadurch, dass sich im Bereich der Aussparungen 44 keinerlei Fäden eines Gewebes oder dergleichen befinden, zeichnen sich auch in den Stegen 32 oder Bögen 34 keine Fäden ab. Auch lässt sich durch Vorgeben der Dicke des Blechs der Schablone 42 eine definierte Höhe der Stege 32 bzw. Bögen 34 vorgeben.

Fig. 4 zeigt schematisch einen der Stege 32. Dieser Steg 32 weist saubere Ränder 48 sowie eine glatte, ebene Oberfläche 50 auf.

Nachdem auf die Oberfläche 38 der Trägerplatte 36 die Stege 32 und Bögen 34 mittels des in Fig. 3 veranschaulichten Verfahrens aufgebracht wurden, wird die Trägerplatte 36 gebrannt. Dadurch verbinden sich die keramischen Stege 32 bzw. Bögen 34 mit der aus Glas gebildeten Trägerplatte 36.

Mittels des in Fig. 3 veranschaulichten Verfahrens lassen sich auf der Oberfläche 38 der Trägerplatte 36 unterschiedliche Strukturelemente ausbilden, u.a. auch einige Buchstaben. Jedoch dienen die Strukturelemente auf dem Touchpad 30 als haptisch erfassbare Fühlhilfen oder Orientierungshilfen. Ein Benutzer des Touchpads 30 kann so, ohne einen Blick auf die Oberfläche 38 werfen zu müssen, verschiedene Bedienbereiche 52, 56, 60 auf dem Touchpad 30 ertasten. Über die Bedienbereiche 52 oder Bedienfelder, welche vorliegend durch die an einem oberen Rand 54 des Touchpads 30 angeordneten, zueinander parallelen, geraden Stege 32 voneinander abgegrenzt sind, können sich beispielsweise Radiostationen aufrufen lassen. Je nach Betriebszustand des Touchpads 30 können jedoch beliebige weitere oder andere Funktionen in diesen Bedienbereichen 52 des Touchpads 30 hinterlegt sein.

Durch die Bögen 34 sind vorliegend weitere Bedienbereiche 56 an seitlichen Rändern des Touchpads 30 abgegrenzt, welche mit anderen Funktionen belegt sein können. An einem unteren Rand 58 des Touchpads 30 ist vorliegend durch einen weiteren der Stege 32 ein weiterer Bedienbereich 60 vom Benutzer ertastbar.

Die vorliegend beispielhaft gezeigten Strukturelemente in Form der Stege 32 und der Bögen 34 können auch an anderen Stellen des Touchpads 30 vorgesehen sein und von den in Fig. 5 beispielhaft gezeigten Formgebungen abweichende Formen aufweisen.

Vorliegend ist die Trägerplatte 36 aus einem Glas gebildet, es können jedoch auch auf einer Trägerplatte 36, welche lediglich eine Oberfläche aus Glas aufweist, die Strukturelemente aus Keramik mittels des anhand von Fig. 3 veranschaulichten Verfahrens aufgebracht werden. Über die Konsistenz der Keramikpaste 48, welche vergleichsweise dickflüssig sein kann, und die Dicke des Blechs der Schablone 42 kann auch hierbei die Höhe der als Fühlhilfen dienenden Strukturelemente eingestellt werden.

Die Keramikpaste 48 kann auch als farbiges pastöses Material ausgebildet sein, um entsprechend farbige Strukturelemente auf der Oberfläche 38 der Trägerplatte 36 auszubilden.

## Patentansprüche

1. Verfahren zum Herstellen eines, insbesondere für einen Kraftwagen vorgesehenen, Bedienelements (30) mit einer berührungsempfindlichen Oberfläche (38), bei welchem auf eine Trägerplatte (36) ein pastöses Material (48) aufgebracht wird,
wobei durch das pastöse Material (48) auf der Trägerplatte (36) wenigstens ein erhabenes Strukturelement (32, 34) ausgebildet wird, indem über der Trägerplatte (36) eine eigensteife, durch ein Blech gebildete Schablone (42) angeordnet und das pastöse Material (48) durch wenigstens eine Aussparung (44) in der Schablone (42) hindurchgedrückt wird, wobei die wenigstens eine Aussparung (44) in der Schablone (42) frei von jeglichen Fäden, Fasern oder Maschen ist, wobei die wenigstens eine Aussparung (44) in der Schablone (42) derart mit dem pastösen Material (48) beaufschlagt wird, dass eine Höhe des wenigstens einen Strukturelements (32, 34) einer Dicke der Schablone (42) entspricht, und wobei durch das wenigstens eine erhabene Strukturelement (32, 34) eine haptisch wahrnehmbare Fühlhilfe für einen Benutzer des Bedienelements (30) bereitgestellt wird.

2. Verfahren nach Anspruch 1,
**dadurch gekennzeichnet, dass**
als pastöses Material ein keramisches Material (48) auf die Trägerplatte (36) aufgebracht wird.

3. Verfahren nach Anspruch 1 oder 2,
**dadurch gekennzeichnet, dass**
das pastöse Material (48) durch Erhitzen mit der, insbesondere aus einem Glas gebildeten, Trägerplatte (36) verbunden wird.

4. Verfahren nach einem der Ansprüche 1 bis 3,
**dadurch gekennzeichnet, dass**
die wenigstens eine Aussparung (44) in der Schablone (42) durch Laserschneiden und/oder durch Stanzen hergestellt wird.

5. Bedienelement zum Ansteuern von Funktionseinheiten eines Kraftwagens, mit einer Trägerplatte (36) und mit einer berührungsempfindlichen Oberfläche (38),
wobei auf der Trägerplatte (36) wenigstens ein erhabenes Strukturelement (32, 34) ausgebildet ist,
**dadurch gekennzeichnet, dass**
das wenigstens eine erhabene Strukturelement (32, 34) durch Hindurchdrücken eines pastösen Materials (48) durch wenigstens eine Aussparung (44) in einer eigensteifen, durch ein Blech gebildeten Schablone (42) hergestellt ist, wobei die wenigstens eine Aussparung (44) in der Schablone (42) frei von jeglichen Fäden, Fasern oder Maschen ist, wobei eine Höhe des wenigstens einen Strukturelements (32, 34) einer Dicke der Schablone (42) entspricht, wobei durch das wenigstens eine erhabene Strukturelement (32, 34) eine haptisch wahrnehmbare Fühlhilfe für einen Benutzer des Bedienelements (30) bereitgestellt ist, und wobei das wenigstens eine erhabene Strukturelement (32, 34) frei von irgendwelchen Unregelmäßigkeiten aufgrund sich abzeichnender Fäden oder dergleichen ist.

6. Bedienelement nach Anspruch 5,
**dadurch gekennzeichnet, dass**
das Bedienelement als Touchpad (30) oder als Touchscreen ausgebildet ist.

## Claims

1. Method for producing a control element (30), in particular a control element provided for a motor vehicle, the control element having a touch-sensitive zone (38), the method comprising applying a paste-like material (48) to a carrier plate (36),
wherein at least one raised structural element (32, 34) is formed on the carrier plate (36) by the paste-like material (48), by arranging an inherently rigid stencil (42) formed by a piece of sheet metal over the carrier plate (36) and pressing the paste-like material (48) through at least one cutout (44) in the stencil (42), wherein the at least one cutout (44) in the stencil (42) is free of any threads, fibers or loops, wherein the paste-like material (48) is applied to the at least one cutout (44) in the stencil (42) in such a way that a height of the at least one structural element (32, 34) corresponds to a thickness of the stencil (42), and wherein a haptically perceptible sensing aid for a user of the control element (30) is formed by the at least one raised structural element (32, 34).

2. Method according to claim 1,
**characterised in that**
a ceramic material (48) is applied to the carrier plate (36) as the paste-like material.

3. Method according to claim 1 or 2,
**characterised in that**
the paste-like material (48) is secured by heating to the carrier plate (36) which is in particular formed from a glass.

4. Method according to any of claims 1 to 3,
**characterised in that**
the at least one cutout (44) in the stencil (42) is produced by laser cutting and/or by punching.

5. Control element for actuating functional units of a motor vehicle, with a carrier plate (36) and a touch-sensitive zone (38), wherein at least one raised structural element (32, 34) is formed on the carrier plate (36),
**characterised in that**
the at least one raised structural element (32, 34) is produced by pressing a paste-like material (48) through at least one cutout (44) in an inherently rigid stencil (42) formed by a piece of sheet metal, wherein the at least one cutout (44) in the stencil (42) is free of any threads, fibers or loops, wherein a height of the at least one structural element (32, 34) corresponds to a thickness of the stencil (42), wherein the at least one raised structural element (32, 34) forms a haptically perceptible sensing aid for a user of the control element (30), and wherein the at least one raised structural element (32, 34) is free of any irregularities owing to threads or the like in the stencil.

6. Control element according to claim 5,
**characterised in that**
the control element is a touchpad (30) or a touchscreen.

## Revendications

1. Procédé de fabrication d'un élément de commande (30), prévu en particulier pour un véhicule automobile, avec une surface tactile (38), pour lequel un matériau pâteux (48) est appliqué sur une plaque porteuse (36),
dans lequel au moins un élément structurel (32, 34) en relief est réalisé par le matériau pâteux (48) sur la plaque porteuse (36), en ce qu'un pochoir (42) rigide, formé par une tôle est agencé au-dessus de la plaque porteuse (36) et le matériau pâteux (48) est pressé au travers d'au moins un évidement (44) dans le pochoir (42), dans lequel l'au moins un évidement (44) dans le pochoir (42) est exempt de tout fil, fibre ou maille, dans lequel l'au moins un évidement (44) dans le pochoir (42) est alimenté en matériau pâteux (48) de sorte qu'une hauteur d'au moins un élément structurel (32, 34) corresponde à une épaisseur du pochoir (42), et dans lequel par l'au moins un élément structurel (32, 34) en relief une aide à la détection perceptible haptiquement est mise à la disposition d'un utilisateur de l'élément de commande (30).

2. Procédé selon la revendication 1,
**caractérisé en ce que**
comme matériau pâteux un matériau céramique (48) est appliqué sur la plaque porteuse (36).

3. Procédé selon la revendication 1 ou 2,
**caractérisé en ce que**
le matériau pâteux (48) est raccordé par chauffage à la plaque porteuse (36), constituée en particulier d'un verre.

4. Procédé selon l'une quelconque des revendications 1 à 3,
**caractérisé en ce que**
l'au moins un évidement (44) dans le pochoir (42) est fabriqué par coupe laser et/ou par estampage.

5. Elément de commande pour la commande d'unités fonctionnelles d'un véhicule automobile, avec une plaque porteuse (36) et avec une surface tactile (38),
dans lequel au moins un élément structurel (32, 34) en relief est réalisé sur la plaque porteuse (36),
**caractérisé en ce que**
l'au moins un élément structurel (32, 34) en relief est fabriqué par pressage d'un matériau pâteux (48) au travers d'au moins un évidement (44) dans un pochoir (42) rigide, formé par une tôle, dans lequel l'au moins un évidement (44) dans le pochoir (42) est exempt de tout fil, fibre ou maille, dans lequel une hauteur d'au moins un élément structurel (32, 34) correspond à une épaisseur du pochoir (42), dans lequel par l'au moins un élément structurel (32, 34) en relief une aide à la détection perceptible haptiquement est mise à la disposition d'un utilisateur de l'élément de commande (30), et dans lequel l'au moins un élément structurel (32, 34) en relief est exempt de toute irrégularité en raison de fils ou similaires émergeant.

6. Elément de commande selon la revendication 5,
**caractérisé en ce que**
l'élément de commande est réalisé comme pavé tactile (30) ou comme écran tactile.
